# EUROPEAN PATENT SPECIFICATION

(11) **EP 0 715 360 B1**
(45) Date of publication and mention of the grant of the patent: **29.09.1999**
(21) Application number: 95118704.6
(22) Date of filing: 28.11.1995
(51) Int. Cl.: H01L 41/187, C04B 35/493

(54) **Piezoelectric ceramic composition**
Piezoelektrische keramische Zusammensetzung
Composition céramique piézo-électrique

(30) Priority: 28.11.1994 JP 31931894
(43) Date of publication of application: 05.06.1996
(73) Proprietor: MURATA MANUFACTURING CO., LTD., Nagaokakyo-shi Kyoto-fu 226 (JP)
(72) Inventor: Hase, Kiyoshi, c/o Murata Man. Co., Ltd., Nagaokakyo-shi, Kyoto-fu (JP); Shiratsuyu, Kosuke, c/o Murata Man. Co., Ltd., Nagaokakyo-shi, Kyoto-fu (JP); Tomono, Kunisaburo, c/o Murata Man. Co., Ltd., Nagaokakyo-shi, Kyoto-fu (JP)
(74) Representative: Laufhütte, Dieter, Dr.-Ing.

(56) References cited:
- US-A- 4 765 919
- PATENT ABSTRACTS OF JAPAN vol. 950 no. 002 & JP-A-07 045883 (MURATA MFG CO LTD) 14 February 1995,
- PATENT ABSTRACTS OF JAPAN vol. 006 no. 247 (E-146) ,7 December 1982 & JP-A-57 145384 (SUMITOMO TOKUSHIYU KINZOKU KK) 8 September 1982,

## Description

The present invention relates to a piezoelectric ceramic composition used for buzzers and piezoelectric actuator elements.

Due to their large piezoelectric constant and large electro-mechanical coupling coefficient, Pb(Ni_{1/3}Nb_{2/3})O₃-PbZrO₃-PbTiO₃-based piezoelectric ceramics (PNN-PZ-PT), obtained by solid dissolving Pb(Ni_{1/3}Nb_{2/3})O₃ in Pb(Zr, Ti)O₃, a typical type of piezoelectric ceramics, are widely used for buzzers and piezoelectric actuator elements (JP-B-45-37907).

A similar ceramic material is known from JP 0745883 A, JP 57145384 A and US 4765919.

Not all PNN-PZ-PT-based ceramics, however, have satisfactory mechanical strength and thus may crack or chip when machined into a piezoelectric element, such as a buzzer.

According to the present invention a piezoelectric ceramic composition is provided, which has a large piezoelectric constant and a large electro-mechanical coupling coefficient and offers satisfactory mechanical strength, thereby solving the above-described problem.

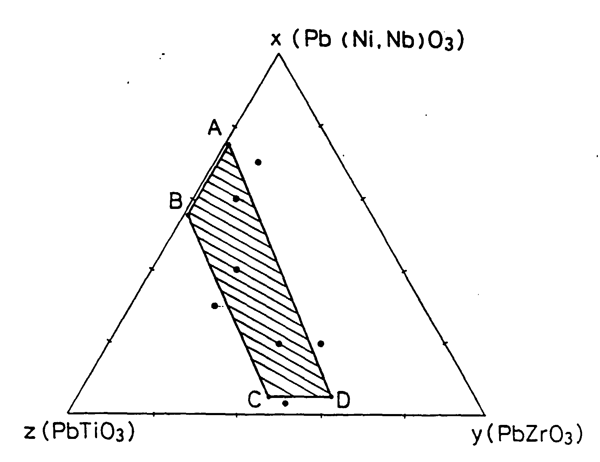

A piezoelectric ceramic composition for the purpose of the specification is a three-component system composed of xPb(Ni_{w/3}Nb_{1-w/3})O₃-yPbZrO₃-zPbTiO₃, wherein points representing the compositional proportions x, y, and z are on lines connecting points
A: (x = 0.75, y = 0.01, z = 0.24),
B: (x = 0.55, y = 0.01, z = 0.44),
C: (x = 0.05, y = 0.45, z = 0.50), and
D: (x = 0.05, y = 0.60, z = 0.35)
and are in the compositional region bounded by the lines in the three-component composition diagram of FIG. 1, and the value of w ranges from 0.85 to 0.95.

In other words, a PNN-PZ-PT-based piezoelectric ceramic composition of the present invention as claimed implies that the Ni-Nb ratio thereof is less than a stoichiometric ratio of 1/2.

The piezoelectric ceramic composition is also characterized by up to fifteen molar percent of Pb atoms replaced by atoms of at least one element selected from the group of Ca, Sr, and Ba.

Reducing the ratio of Ni to Nb to below the stoichiometric ratio of 1/2 as claimed causes the diameter of particles constituting ceramics to be reduced and the mechanical strength thereof to be increased.

What is more, increased mechanical strength does not adversely affect the piezoelectric constant and the electro-mechanical coupling coefficient.

### BRIEF DESCRIPTION OF THE DRAWINGS

FIG. 1 is a three-component composition diagram showing the proportions of the components of a PNN-PZ-PT piezoelectric ceramic composition of the present invention.

Referring now to embodiments, advantages of the present invention are specifically described below.

A predetermined amount of components of a piezoelectric ceramic composition, such as PbO, TiO₂, ZrO₂, SrCO₃, CaCO₃, BaCO₃, NiO, and Nb₂O₅, was measured, and water was added to the measured substances and mixed them using a ball mill.

The resulting mixture was dried, incompletely calcined at about 700 to 900°C for about two hours, and water-ground using a ball mill to obtain an adjusted powder.

Binders, such as water and polyvinyl alcohol, were added to the resulting adjusted powder, and then the mixture was pressed and calcined at about 1100 to 1300°C for approximately two hours to obtain piezoelectric ceramics of a predetermined composition.

The piezoelectric ceramics were worked to prepare samples for three-point bending strength testing and electrical characteristic measurements. For instance, samples for three-point bending strength testing were prepared by forming some of the piezoelectric ceramics into 30 mm x 5 mm x 0.3 mm rectangles. Also, samples for electrical characteristic measurements were prepared by forming the remaining piezoelectric ceramics into disks 10 mm in diameter and 1 mm thick, polishing the disks, depositing silver electrodes onto both sides of the disks by baking, and polarizing the disks in insulating oil at about 80°C for 30 minutes, with an electric field with a strength of 2 to 3 kV/mm imposed on the oil.

Comparison samples were formed from piezoelectric ceramics outside the scope of the present invention as claimed in the same way as the samples of the embodiment.

The above-described samples of the embodiment and the comparison samples underwent three-point bending strength testing and measurements of the electro-mechanical coupling coefficient for vibration in a radius direction. The results are shown in Table 1.

**Table 1**

| Sample No. | x | y | z | w | A | a | Three-point bending strength N/cm² (kgf/cm²) | Electromechanical coupling coefficient Kp (%) |
|---|---|---|---|---|---|---|---|---|
| *1 | 0.70 | 0.10 | 0.20 | 0.95 | Sr | 0.02 | 11270 (1150) | 18.4 |
| 2 | 0.60 | 0.10 | 0.30 | 0.95 | Sr | 0.02 | 11172 (1140) | 45.3 |
| 3 | 0.40 | 0.20 | 0.40 | 0.95 | Sr | 0.02 | 10486 (1070) | 65.8 |
| *4 | 0.30 | 0.20 | 0.50 | 0.95 | Sr | 0.02 | 10486 (1070) | 17.8 |
| 5 | 0.20 | 0.40 | 0.40 | 0.95 | Sr | 0.02 | 10290 (1050) | 62.3 |
| *6 | 0.20 | 0.50 | 0.30 | 0.95 | Sr | 0.02 | 10192 (1040) | 23.4 |
| *7 | 0.03 | 0.50 | 0.47 | 0.95 | Sr | 0.02 | 8722 (890) | 56.7 |
| *8 | 0.40 | 0.20 | 0.40 | 1.00 | Sr | 0.02 | 8820 (900) | 70.1 |
| 9 | 0.40 | 0.20 | 0.40 | 0.85 | Sr | 0.02 | 10486 (1170) | 55.2 |
| *10 | 0.40 | 0.20 | 0.40 | 0.80 | Sr | 0.02 | 12152 (1240) | 32.4 |
| *11 | 0.03 | 0.50 | 0.47 | 0.85 | Sr | 0.02 | 8918 (910) | 51.2 |
| 12 | 0.20 | 0.40 | 0.40 | 0.95 | - | - | 10388 (1060) | 57.8 |
| 13 | 0.20 | 0.40 | 0.40 | 0.95 | Sr Ba Ca | 0.04 0.04 0.04 | 10486 (1070) | 48.1 |
| *14 | 0.20 | 0.40 | 0.40 | 0.95 | Sr | 0.20 | 10388 (1060) | 29.7 |

In Table 1, symbols x, y, z, and w represent the molar proportions of components of xPb(Ni_{w/3}Nb_{1-w/3})O₃-yPbZrO₃-zPbTiO₃, and symbols A and a represent the type of element replacing Pb (i. e., Sr, Ba, or Ca) and the molar percentage of the element, respectively.

The asterisked marked sample numbers in the table indicate piezoelectric ceramics (comparison samples) outside the scope of the present invention as claimed.

As shown in Table 1, a piece of piezoelectric ceramic (sample No. 8) whose w value is substantially 1 or more was found to be low in three-point bending strength, and a piece of piezoelectric ceramic (sample No. 10) whose w value is substantially 0.8 or less was found to have a low electro-mechanical coupling coefficient Kp.

The electro-mechanical coupling coefficient Kp was found to be reduced if the percentage of Pb atoms replaced with those of at least one type of element selected among Ca, Sr, and Ba substantially exceeds 0.15 (15%) (sample No. 14).

The electro-mechanical coupling coefficient Kp was found to be significantly reduced if the composition of PNN-PZ-PT is not as shown in Fig. 1 (samples No. 1, 4, 6, 7, and 11).

Setting the value of w to below 1 was found to unsatisfactorily improve mechanical strength, particularly if in the compositional proportion of PNN, x is less than 0.05 (samples No. 7 and 11).

As described above, having a large piezoelectric constant, a large electro-mechanical coupling coefficient Kp, and high mechanical strength, the piezoelectric ceramic composition of the present invention as claimed enables piezoelectric elements having advantages necessary for buzzers and piezoelectric actuator elements to be produced in high yield by inhibiting the occurrence of defects, such as cracks and chips, during machining operation.

## Claims

1. A three-component piezoelectric ceramic composition composed of xPb xPb(Ni_{w/3}Nb_{1-w/3})O₃-yPbZrO₃-zPbTiO₃, in which up to fifteen molar percent of Pb atoms are replaced with at least one element selected from the group of Ca, Sr and Ba, and x+y+z=1, wherein points representing the compositional proportions x, y and z are on lines connecting points
A: (x = 0.75, y = 0.01, z = 0.24),
B: (x = 0.55, y = 0.01, z = 0.44),
C: (x = 0.05, y = 0.45, z = 0.50), and
D: (x = 0.05, y = 0.60, z = 0.35)
or in the compositional region bounded by those lines in a three-component composition diagram, and the value of w ranges from 0.85 to 0.95.

2. The piezoelectric ceramic composition according to claim 1, wherein up to fifteen molar percent of said Pb are replaced with Sr.

3. The piezoelectric ceramic composition according to claim 1, wherein up to fifteen molar percent of said Pb are replaced with a combination of Ca, Sr and Ba.

4. The piezoelectric ceramic composition according to one of the claims 1-3, wherein x is 0.20-0.60.

5. The piezoelectric ceramic composition according to one of the claims 1-4, wherein y is 0.10-0.40.

6. The piezoelectric ceramic composition according to one of the claims 1-5, wherein z is 0.3 -0.4.

## Patentansprüche

1. Piezoelektrische Drei-Komponenten-Keramikmasse, bestehend aus xPb(Ni_{w/3}Nb_{1-w/3})O₃-yPbZrO₃-zPbTiO₃, worin bis zu 15 Mol-% Pb-Atome ersetzt sind durch mindestens ein Element, gewählt aus der Gruppe aus Ca, Sr und Ba, und x+y+z=1 ist, worin die die Zusammensetzungsverhältnisse x, y und z darstellenden Punkte auf Linien liegen, verbindend die Punkte
A: (x = 0,75, y = 0,01, z = 0,24),
B: (x = 0,55, y = 0,01, z = 0,44),
C: (x = 0,05, y = 0,45, z = 0,50) und
D: (x = 0,05, y = 0,60, z = 0,35),
oder in dem Zusammensetzungsbereich liegen, der durch jene Linien in einem Drei-Komponenten-Zusammensetzungsdiagramm eingegrenzt wird, und der Wert von w im Bereich von 0,85 bis 0,95 liegt.

2. Piezoelektrische Keramikmasse gemäß Anspruch 1, in der bis zu 15 Mol-% des Pb durch Sr ersetzt sind.

3. Piezoelektrische Keramikmasse gemäß Anspruch 1, in der bis zu 15 Mol-% des Pb durch eine Kombination von Ca, Sr und Ba ersetzt sind.

4. Piezoelektrische Keramikmasse gemäß mindestens einem der Ansprüche 1 bis 3, worin x 0,20 - 0,60 ist.

5. Piezoelektrische Keramikmasse gemäß mindestens einem der Ansprüche 1 bis 4, worin y 0,10 - 0,40 ist.

6. Piezoelektrische Keramikmasse gemäß mindestens einem der Ansprüche 1 bis 5, worin z 0,3 - 0,4 ist.

## Revendications

1. Composition céramique piézo-électrique à trois composants, composée de xPb(Ni_{w/3}Nb_{1-w/e})O₃-yPbZrO₃-zPbTiO₃, formule dans laquelle jusqu'à quinze pour-cent molaires d'atomes de plomb sont remplacés par au moins un élément sélectionné parmi le groupe Ca, Sr et Ba, et x+y+z = 1, dans laquelle des points représentant les proportions de composition x, y et z se trouvent dans des points connectant des lignes
A : (x = 0,75, y = 0,01, z = 0,24)
B : (x = 0,55, y = 0,01, z = 0,44)
C : (x = 0,05, y = 0,45, z = 0,50) et
D : (x = 0,05, y = 0,60, z = 0,35)
ou dans la région de composition délimitée par ces lignes dans un diagramme de composition à trois composants, et la valeur de w se situe entre 0,85 et 0,95.

2. Composition céramique piézo-électrique selon la revendication 1, dans laquelle jusqu'à quinze pour-cent molaires dudit Pb sont remplacés par Sr.

3. Composition céramique piézo-électrique selon la revendication 1, dans laquelle jusqu'à quinze pour-cent molaires dudit Pb sont remplacés par une combinaison de Ca, Sr et Ba.

4. Composition céramique piézo-électrique selon l'une quelconque des revendications 1 à 3, dans laquelle x va de 0,20 à 0,60.

5. Composition céramique piézo-électrique selon l'une quelconque des revendications 1 à 4, dans laquelle y va de 0,10 à 0,40.

6. Composition céramique piézo-électrique selon l'une quelconque des revendications 1 à 5, dans laquelle z va de 0,3 à 0,4.
